# EUROPEAN PATENT SPECIFICATION

(11) **EP 1 801 845 B1**
(45) Date of publication and mention of the grant of the patent: **09.02.2011**
(21) Application number: 05028356.3
(22) Date of filing: 23.12.2005
(51) Int. Cl.: H01J 37/32

(54) **Plasmachemical microwave reactor**
Plasma-chemischer Mikrowellenreaktor
Réacteur plasmachimique à micro-ondes

(43) Date of publication of application: 27.06.2007
(73) Proprietor: Obschestvo S Ogranichennoi Otvetstvennostiyu "TWINN", 117216 Moscow (RU)
(72) Inventor: Lysov, Georgy Vassillevich, 117216 Moscow (RU); Leontiev, Igor Anatolievich, 119333 Moscow (RU); Nikolaev, Andrei Anatollevich, 125252 Moscow (RU); Chernomyrdin, Vitaly Viktorovich, 117437 Moscow (RU); Kliamko, Andrei Stanislavovich, 197046 Sankt-Peterburg (RU)
(74) Representative: Bugnion Genève

(56) References cited:
- EP-A- 0 506 484
- RU-C- 2 225 684
- RU-C1- 2 149 521
- US-A- 6 060 836
- PATENT ABSTRACTS OF JAPAN vol. 015, no. 211 (C-0836), 29 May 1991 (1991-05-29) & JP 03 061371 A (NEC CORP), 18 March 1991 (1991-03-18)
- PATENT ABSTRACTS OF JAPAN vol. 012, no. 063 (E-585), 25 February 1988 (1988-02-25) & JP 62 204530 A (HITACHI LTD), 9 September 1987 (1987-09-09)
- PATENT ABSTRACTS OF JAPAN vol. 013, no. 468 (E-834), 23 October 1989 (1989-10-23) & JP 01 183036 A (NISSIN ELECTRIC CO LTD), 20 July 1989 (1989-07-20)

## Description

### Field of the Invention

The invention relates to plasmachemical reactors having an enlarged plasma volume and an increased amount of electric energy inputted into the discharge.

The disclosed apparatus is intended for direct reduction of metals from ores, for lighting the electric melting furnaces, synthesis of powdered materials, spheroidization of powders, deposition of films, and in other arts.

### Background of the Invention

The microwave plasma can be suitably utilized in various plasma technologies based on realisation of: non-balanced effects, the space discharge and controllability of the basic plasma properties; without use of any electrodes to be eroded in the course of a technological process.

For the electrometallurgy processes, the electric-arc plasmatrons are conventionally proposed. But despite long years attempts, any arrangement, suitable for commercialisation, could not be created due to intensive erosion of the cathode, which circumstance hinders use of the plasma technologies for direct reduction of metals from ores.

The microwave plasmatrons are completely free of this disadvantage. However, the industry still has failed to commercialise production of relatively inexpensive microwave sources that would provide required power. Drawbacks of the devices based on the microwave plasmachemical technologies have been caused by a low capacity of the employed equipment due to paucity of the energy inputted into the discharge.

Known is a microwave plasmachemical reactor, wherein by maintaining the discharge at the electric field intensity value being less than the break-down value, and owing to creation of the conditions for gas circulation in the discharge zone, and using of the microwave mode having, at the discharge boundary the electric field intensity vector normal to said wave, the ionized gas flow exiting out of the energy absorption main zone, re-enters said zone, while retaining the ionization degree that determines the conductivity that is sufficient for absorption of the microwave energy. As this occurs, the diffusive (relatively uniform across the volume) nature of the discharge under the gas pressure approximating or exceeding the atmospheric pressure is retained because the ionizing unsteadiness of the plasma channel of the used mode of the microwave has been eliminated. In such reactor, reliability of the devices that perform inputting of energy is provided by disposing the energy input windows at the locations where they are not exposed to the plasma radiation (RU patent Nº149521, 2000).

A drawback of said known device is a low specific energy contribution made to the near-axis zone of the discharge, hence -low technological efficiency of such device.

The prototype of the disclosed reactor, wherein said drawback has been eliminated, is a microwave plasmachemical reactor that comprises:
a metal discharge chamber in the form of a cylindrical tube having end-face bottoms and a sidewall,
a unit for inputting the microwave energy into the discharge chamber, which energy-inputting unit is implemented in the form of two coaxial metal tubes that consist of the external tube having the upper bottom and of the internal tube;
a transition arrangement consisting of: a metal body in the form of a truncated cone whose greater base forms a portion of the discharge chamber upper bottom surrounding the internal tube; and a metal housing that surrounds the metal body coaxially to said body and connects the external tube to the discharge chamber sidewall;
a coaxial-waveguide junction whose outer conductor-enclosure is coupled to the upper bottom of the microwave-energy inputting unit and is insulated against the internal tube by a dielectric ring, wherein
   one end of the central conductor has the faired mating with the internal tube upper end and insulated against the enclosure; and
   the external tube wall being provided with windows, to which windows rectangular waveguides are coupled such that their broader walls are oriented in parallel with the discharge chamber axis, the windows themselves being closed by dielectric inserts;
a pad for placement of a treated material thereon, which pad is positioned on the discharge chamber lower bottom and is adapted to move;
a sealing dielectric window disposed between the housing and the metal body;
a former of the additional vortex gas flow;
an ignitor electrode mounted on the discharge chamber sidewall, and nozzles for inputting the working gas, positioned tangentially with respect to the wall, and
gas-release openings provided in the lower bottom (RU patent 2225684, 2000).

The applicant studied a possibility to combine the microwave-discharge burning patterns with arc discharge in such reactor, and ascertained that passage of direct current through the microwave-discharge plasma column not only does not destroy the column, as it could be surmised in view of essential differences in terms of the physical processes effected in both discharge types and in terms of their power, but also stabilises the microwave-discharge; further owing to the combination of the electric microwave-fields created by the microwave plasmatron and of their concentration under the cathode: the microwave-discharge creates the physical states, which are conducive to excitation and stabilisation of the arc discharge and to formation of the running arc spot on the cathode surface, and also prevent the cathode from being eroded. The claimed apparatus thus acquires the novel qualities - stability and service life that were not inherent to the above-mentioned processes and to each one of the apparatuses using them.

### Summary of the Invention

The objective to be attained by the claimed apparatus consists in provision of a broader field of utilisation of the plasma-based processes by use of the discharge excited by the microwave energy, and in devising a plasmachemical reactor capable of ensuring execution of the high-energy technological processes.

The technical effect to be achieved consists in elimination of the prior-art restrictions imposed upon the energy inputted into the plasma discharge, and in a substantial increase in said energy while preserving the inherent to the microwave plasma-based devices features of the absence of eroded electrodes and simple controlling of a process; as well as provision of a steady operation and extended service life.

Said technical effect is attained as follows: in a plasmachemical reactor, in its internal tube, at its end-face oriented towards the discharge chamber - positioned is an insert of a conductive material having a central opening, which insert is secured on the tube inner surface using projections and is implemented essentially as a body of revolution;
the second end of the central conductor of the coaxial-waveguide junction is coupled to a feed meter;
a sealing dielectric cylinder being inserted between the metal body tapered surface and the external tube wall, coaxially with the latter; and
a former of the additional vortex gas flow being positioned within a housing around the dielectric cylinder;
a metal tube being positioned in the discharge chamber lower bottom centre and being adapted to move with respect to said bottom;
inside said metal tube positioned is a means for placing a feed and collecting a final product, said means being implemented as a pad;
the conductive insert being connected to the negative pole of a voltage source, and the metal tube being connected to the positive pole thereof;
a solenoid being positioned around the discharge chamber; and
the metal tube wall can be provided with openings.

An increase in the energy inputted into the microwave discharge is carried out by a transition arrangement consisting of two waveguides and dielectric windows, which arrangement is mounted on the external tube - in accordance with the most pertinent art.

### Brief Description of Drawings

Fig. 1 shows an embodiment of the claimed disclosed apparatus.
Fig. 2 shows a cross-section of the claimed plasmachemical reactor having means for supplying energy from additional microwave sources.

The claimed microwave plasmachemical reactor consists of:
cylindrical discharge chamber 1 comprised of lower 2 and upper 3 bottoms and sidewall 4; on lower bottom 2 of said chamber in moveable metal tube 5 positioned is pad 6 to accommodate a plasma-treated material or to collect a final product;
coaxial-waveguide junction 7 having hollow central conductor 8 and external conductor 9;
unit 10 for inputting the microwave energy, which unit includes internal 11 and external 12 tubes having upper bottom 13; and
a cone-shaped transition arrangement 14 having metal housing 15 and metal body 16 disposed in said housing.
In sidewall 4 of discharge chamber 1, nozzles 17 are arranged tangentially to sidewall 4 for supplying a gas mixture into the discharge chamber; and lower bottom 2 of discharge chamber 1 has openings 18 to release the gas mixture. In the same wall, moveable rod-shaped electrode 19 is positioned on sealed bellows and is intended to initiate the microwave discharge.

Central conductor 8 of junction 7 is coupled, via faired transition 20, to internal tube 11; and external conductor 9 being coupled to upper bottom 13 of inputting unit 10 and being insulated against tube 11 using dielectric cylinder 21; external conductor 9 accommodates choke 22 that prevents the microwave energy from emitting outwards along conductor 8 towards a feed meter (not shown in the drawings); outlet pipe 23 of said meter being mechanically coupled to conductor 8 through insulator 24.

Cone-shaped housing 15, by its smaller base, is coupled to the lower portion of external tube 12 of the inputting unit, by its greater portion said housing is coupled to sidewall of discharge chamber 1;
body 16 being implemented as a truncated cone having a central opening and being secured outside the internal tube 11;
sealing window 25, separating the working volume of discharge chamber 1 from the inner space of inputting unit 10, is implemented as a cylinder and disposed in the gap between the body 16 cone-shaped surface and housing 15;
former 26 of the additional gas flow, that is directed into discharge chamber 1, is positioned around cylinder 25 on the joint of tube 12 and housing 15.

Conductive insert 27, having the central opening and being secured on the tube 11 inner surface using projections, is positioned within internal tube 11 - at its lower end-face that is oriented towards discharge chamber 1.

The tube 5 wall can be provided with openings 28 for release of the gas mixture. Moveable tube 5 is connected to the positive pole; insert 27 - via internal tube 11 and central conductor 8 - is connected to the negative pole of a voltage source (not shown in the drawings). Solenoid 29 is positioned around discharge chamber 1.

Means for supplying the additional microwave energy are coupled to inputting unit 10 through windows 30 installed in external tube 12; rectangular waveguides 31 being connected to said windows such that their broader wall are parallel with the tube 12 axis - similarly to the most pertinent art. Two dielectric windows 30 are installed in the tube 12 wall and shifted by 90° by azimuth. Waveguides 31 excite the transverse electric mode, along the coaxial line, within the space between external 12 and internal 11 tubes.

Coaxial-waveguide junction 7 is a device that converts the waves, propagating from the microwave-energy source in a rectangular waveguide, into this or other type of a wave of the coaxial line. In the claimed apparatus, the lowest transverse electric mode of the rectangular waveguide is converted into the TEM-coaxial waveguide mode, which mode excites the electric mode in discharge chamber 1.

Faired transition 20 serves the purpose to match resistances of the coaxials constituted by central conductor 8 and external conductor 9, on the one side, and internal tube 11 and external tube 12, on the other side.

The apparatus members that are heated in the course of the technological process, inclusive of internal tube 11, discharge chamber 1 and conductive insert 27, if necessary, can be adapted to be cooled. But to enable control of temperature of insert 27 (usually made of graphite, tungsten and other refractory metals), and also to achieve a temperature sufficient for effecting the thermionic emission in the beginning of the process, the preferable method will be a restrained heat removal from said insert, for example - by diminishing the surface wherewith the insert contacts internal tube 11, using projections on the outer surface of insert 27, sizes of which projections may vary depending on the supplied power.

An essential increase in the discharge power and, accordingly, the power of heat radiation of the discharge required to transfer the dielectric window that insulates the microwave energy supplying devices against the discharge chamber working volume, and to dispose the window between the metal body 16 cone-shaped surface and the external tube 12 lower end, and to modify its shape from the discoid, as in the most pertinent art, to cylinder 25 in the claimed apparatus. Former 26 of the additional vortex flow is positioned around cylinder 25 for cooling the same.

Outlet openings 18 are located on radius r = (0.6 - 0.8)R, where R is the radius of chamber 1, similarly to the most pertinent art. Diameter of outlet openings 18 is selected to observe the condition of preventing any microwave energy from emitting outwards therethrough, and a number of the openings exerts influence on uniformity of the outer boundary of the circulating vortex gas flow, and said number should be at least four.

Height of discharge chamber 1 is selected in view of the condition to absorb the entire supplied microwave energy.

### Embodiment of the Invention

The claimed apparatus, with the aim to provide direct reduction of a metal, is operated as follows. By activation of a microwave source, the microwave energy is delivered into the plasmachemical reactor through coaxial-waveguide junction 7, whereby in discharge chamber 1 the axial-symmetric mode E₀₁ is excited. The field lines of said mode are concentrated at the near-axis zone of discharge chamber 1, which circumstance (after initiation of the discharge with ignitor rod 19) facilitates formation of the microwave discharge under the internal tube 11 end-face - the holder of conductive insert 27 that acts as the negative electrode (cathode) of the arc discharge. The working gas mixture is blown into discharge chamber 1 through nozzles 17 and former 26. In the near-axis zone formed is the circulation gas flow wherein the plasma initiation occurs. Once the plasma has occupied the cathode 27 end-face zone, the end-face surface is heated, and when voltage is supplied on said end-face with respect to metal tube 5, then in discharge chamber 1 the arc discharge will emerge.

The spent plasma-generating gas exits mainly via openings 18 in bottom 2 and, partly via openings 28 in metal tube 5. The feed is delivered through the upper end of central conductor 8 of coaxial-waveguide junction 7; and the final product is collected within metal tube 5, or off pad 6 that is placed therein. In case of the necessity to heat the dielectric material (ore - Fe₂O₃, MgCO₃, etc.), the materials are placed on pad 6, heated by microwave plasma flow, and once conductivity has been brought about, the arc-operation is activated. Then the charge in the form of a powder is delivered.

By use of heating of the surface of insert-cathode 27, that faces discharge chamber 1, to the thermionic emission temperature by the diffusive microwave discharge, which discharge is adjacent to said surface; by use of the field emission across the entire cathode surface under the action of the spatial charge of the positive ions evenly distributed under said surface and created as a result of ionisation of the gas by the microwave field, - thereby the equal conditions for the arc discharge are procured along the entire cathode surface. By virtue of said circumstances, the arc discharge is excited steadily and smoothly, and the arc spot in the solenoid's magnetic field moves evenly, without halts and surges, which are the feature of the conventional arc discharge techniques.

Furthermore, as distinct from the conventional arc discharge techniques wherein the discharge current flow is provided completely by emission of electrons from the periodically stabilised arc spots on the cathode, which is the cause of its rapid destruction, in the claimed reactor the thermionic emission and field emission of the cathode play the main role only at the step of excitation of the arc discharge. Afterwards the cathode mainly loses the electron-emitter function and acquires that of the collector of the positive ions arriving from the discharge. The current flow and heating of the material contained on the anode take place owing to the electrons appeared in the discharge plasma - mainly as the consequence of the presence of the microwave field near the cathode surface. As the discharge is diffusive as a result of the employed means, then deposition of the positive ions on the cathode takes place evenly along entire surface thereof. Thus the causes of destruction of the cathode are avoided.

The joint action exerted on plasma by: the microwave field, and direct current; and by compensation, using direct current, of the microwave energy release in the central zone occurring due to skinning of the electromagnetic field (attenuation from periphery towards the axis) - results in formation of an high-temperature channel in the plasma, in which channel density of the gas is lower than that at microwave-plasma formation front; and thereby evolution of the microwave discharge exactly in that zone is facilitated, and transfer of the discharge against the microwave energy flow is prevented. Thus, the discharge is stabilised in said zone.

The combination of the microwave discharge and arc discharge in the claimed invention allows to use advantages of both plasma-based processes, mitigate their drawbacks and obtain the novel qualities. Thus, the arc discharge enables input of the required energy, allows to lower the requirements to be met by capacity of expensive microwave sources, and provides conditions for stabilising the microwave discharge. The microwave discharge heats the cathode to the thermionic emission temperature, creates the space charge of the positive ions at the cathode surface, which charge makes for emergence of the field emission, ensures smooth movement of the arc spot along the cathode surface, thus preventing or significantly reducing erosion thereof, thereby eliminating the restrictions imposed with respect to a longer service life of the apparatus, facilitates formation of the arc discharge owing to ionisation of the gas within the whole volume of the discharge chamber, and stabilises the discharge.

The possibility to combine the plasma microwave discharge and arc discharge has been ascertained by the inventor for the first time, and any publication concerning this technical solution has not appeared anywhere heretofore.

Additional possibilities for controlling the near-cathode processes in plasma become feasible in case of use of the pulsed techniques for supplying the microwave energy, which techniques allow to increase considerably intensity of the microwave electric field at cathode 27 and ensure achievement of the aforementioned effect with a low total average capacity of microwave sources.

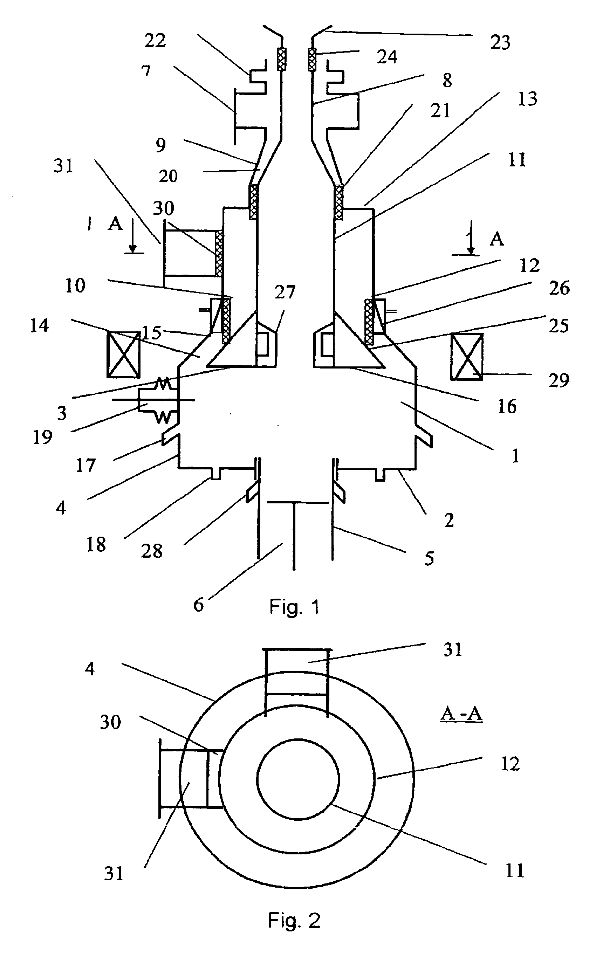

If there is the necessity to enhance the microwave energy inputted into the discharge and enlarge the plasma column diameter, then one or two microwave sources coupled to waveguides 31 mounted on external tube 12 of the microwave energy input unit 10 are turned on - Fig 2. In such case, in discharge chamber 1 either the transverse electric mode having circular polarisation (when the microwave energy is inputted from a single source through two waveguides disposed at angle of 90° in azimuth with respect to one another, the difference of the electrical distances of the waveguiding arms from the microwave energy divider to tube 12 also being 90°), or two orthogonally polarised transverse electric modes (from two different microwave sources) are excited.

In the former case, owing to rotation of the electromagnetic wave polarisation vector - the whole microwave energy is evenly distributed over surface area of the annular gap existing between metal body 16 and housing 15. In the latter case, the microwave power pulses from different sources (in the pulsed mode) undergo the temporal shift with respect to one another. For this reason the microwave sources do not hamper each other's operation, and the total microwave power is evenly distributed in the annular gap.

The claimed apparatus offers new opportunities for employment of the plasmachemical reactors, which previously were hard to obtain technically. For instance, delivery of a feed into the cathode spot zone in an arc plasmatron, and provision of residence of the feed in the arc channel due to chaotic movement of the arc across the cathode surface, and contraction of the arc channel are known to be practically impossible. In the claimed apparatus, the whole end-face zone under the feed input opening is filled with the microwave discharge plasma, and within said zone around said opening the arc channel evenly rotates, the microwave energy - releasing at periphery of the arc channel that has an higher temperature owing to skinning of the microwave field - prevents contraction of the plasma channel.

Such conditions of formation of the plasma column allow to employ this apparatus for the technological processes that require consumption of great amounts of energy to obtain a final product, e.g. - for reducing metals from ores, including the refractory metals.

## Claims

1. A microwave plasmachemical reactor, comprising:
a metal discharge chamber (1) in the form of a cylindrical tube having an upper bottom (3), a lower bottom (2) and a sidewall (4),
a unit (10) for inputting the microwave energy into the discharge chamber (1), which energy-inputting unit is implemented in the form of two coaxial metal tubes (11, 12) that consist of an external tube (12) having an upper bottom (13) and of an internal tube (11);
a transition arrangement (14) consisting of: a metal body (16) in the form of truncated cone whose greater base forms a portion of the discharge chamber upper bottom (3) surrounding the internal tube (11), and a metal housing (15) that surrounds the metal body (16) coaxially to said body and connects the external tube (12) to the discharge chamber sidewall (4);
a coaxial-waveguide junction (7) whose outer conductor-enclosure (9) is connected to the upper bottom (13) of the microwave-energy inputting unit (10) and is insulated against the internal tube (11) by a dielectric ring (21), wherein
the central conductor (8) has the faired mating (20) with the internal tube (11) upper end-face and insulated against the enclosure (9); and
a pad (6) for placement of a feed and collecting a final product, which pad is positioned on the discharge chamber lower bottom (2) and is adapted to move;
a sealing dielectric window disposed between the housing (15) and the metal body (16);
a former (26) of the additional vortex gas flow;
an ignitor electrode (19) mounted on the discharge chamber sidewall (4), and nozzles (17) intended for inputting the working gas and being positioned tangentially with respect to the sidewall (4), and
gas-release openings (18) provided in the lower bottom (2);
**characterised in that**
in said plasmachemical reactor, in its internal tube (11), at said tube's end-face oriented towards the discharge chamber (1) positioned is an insert (27) of a conductive material having a central opening, which insert is secured on the tube (11) inner surface using projections and is implemented essentially as a body of revolution;
the second end of the central conductor (8) of the coaxial-waveguide junction (7) is coupled to a feed meter;
said sealing dielectric window is implemented as a sealing dielectric cylinder (25) being inserted between the metal body cone-shaped surface and the external tube wall, coaxially with the latter; and
said additional vortex gas flow former (26) being positioned within the housing (15) around the dielectric cylinder (25);
a metal tube (5) being positioned in the discharge chamber lower bottom centre and being adapted to move with respect to said bottom (2);
inside said metal tube (5) positioned is said pad (6) for placement of a feed and collecting a final product ;
the conductive insert (27) being connected to the negative pole of a voltage source, and the metal tube (5) being connected to the positive pole thereof; and
a solenoid (29) being positioned around the discharge chamber (1).

2. The apparatus as claimed in Claim 1, **characterised in that** in the external tube wall arranged are two windows (30) which are spaced in azimuth by 90°; to which windows rectangular waveguides (31) are coupled such that their broader walls are oriented along the discharge chamber (1) axis; and the waveguide-connection windows being covered by dielectric inserts.

## Patentansprüche

1. Plasma-chemischer Mikrowellenreaktor,
mit einer metallischen Entladungskammer (1) in Form eines zylindrischen Rohrs mit einem oberen Boden (3), einem unteren Boden (2) und einer Seitenwandung (4),
mit einer Einheit (10) zum Einleiten der Mikrowellenenergie in die Entladungskammer (1), wobei die Einheit zum Einleiten der Energie als zwei koaxiale Metallrohre (11, 12) ausgeführt ist, welche aus einem Aussenrohr (12) mit einem oberen Boden (13) und einem Innenrohr (11) bestehen;
mit einer Übergangsanordnung (14) aus einem Metallkörper (16) in Form eines Kegelstumpfes, dessen grössere Grundfläche einen Teil des oberen Bodens (3) der Entladungskammer bildet und das Innenrohr (11) umgibt, und einem Metallgehäuse (15), das den Metallkörper (16) koaxial zum genannten Boden umgibt und das AussenrOhr (12) mit der Seitenwandung (4) der Entladungskammer verbindet;
mit einer koaxialen Hohlleiter-Verbindung (7), deren äussere Leiterumhüllung (9) mit dem oberen Boden (13) der Einheit (10) zum Einleiten der Mikrowellenenergie verbunden ist und mit einem dielektrischen Ring (21) gegen das Innenrohr (11) isoliert ist;
wobei der mittige Leiter (8) sich verjüngend (20) gegen die obere Endfläche des Innenrohrs (11) verläuft und gegen die Umhüllung (9) isoliert ist; und
mit einer Unterlage (6) zum Auflegen eines Zufuhrprodukts und Sammeln eines Endprodukts, wobei die Unterlage am unteren Boden der Entladungskammer (2) beweglich angeordnet ist;
mit einem dichtenden dielektrischen Fenster zwischen dem Gehäuse (15) und dem Metallkörper (16);
mit einem Leitkanal (26) für eine zusätzliche Wirbelgasstömung;
mit einer Zündelektrode (19), die in der Seitenwandung (4) der Entladungskammer angebracht ist, und mit Düsen (17) zum Einleiten des Arbeitsgases, welche tangential in der Seitenwandung (4) angeordnet sind, und
mit Gasauslassöffnungen (18) im unteren Boden (2), **dadurch gekennzeichnet,**
**dass** beim genannten plasma-chemischen Mikrowellenreaktor in dessen Innenrohr (11) ein Einsatz (27) aus einem leitfähigen Material mit einer mittigen Öffnung an der genannten Endfläche des Rohrs, die gegen die Entladungskammer (1) gerichtet ist, eingebaut ist, wobei der Einsatz an der Innenfläche des Rohrs (11) unter Verwendung von Vorsprüngen befestigt und im wesentlichen als Rotationskörper ausgestaltet ist;
**dass** das zweite Ende des mittigen Leiters (8) der Verbindung (7) des koaxialen Hohlleiters mit einem Zufuhr-Messgerät verbunden ist;
**dass** das genannte dichtende dielektrische Fenster als dichtender dielektrischer Zylinder (25) ausgebildet ist, der zwischen der konischen Oberfläche des Metallkörpers und der äusseren Rohrwandung koaxial mit dieser eingesetzt ist; und
**dass** der genannte Leitkanal (26) für eine zusätzliche Wirbelgasstömung im Gehäuse (15) rund um den dielektrischen Zylinder (25) angeordnet ist;
**dass** ein Metallrohr (5) im Mittelbereich des unteren Bodens der Entladungskammer angebracht ist und gegenüber diesem Boden (2) verschiebbar ist, wobei die genannte Unterlage (6) zum Auflegen eines Zufuhrprodukts und Sammeln eines Endprodukts im Inneren des genannten Metallrohrs (5) angeordnet ist;
**dass** der leitfähige Einsatz (27) mit dem negativen Pol einer Spannungsquelle und das Metallrohr (5) mit deren positivem Pol verbunden ist; und
**dass** ein Elektromagnet (29) rings um die Entladungskammer (1) angebracht ist.

2. Vorrichtung nach Anspruch 1, **dadurch gekennzeichnet, dass** in der äusseren Rohrwandung zwei Fenster (30) vorgesehen sind, deren horizontaler Winkelabstand 90° beträgt und welche mit rechteckigen Hohlleitern (31) derart verbunden sind, dass deren breitere Wandungen auf die Achse der Entladungskammer (1) ausgerichtet sind, und dass die Hohlleiter-Verbindungsfenster mit dielektrischen Einsätzen abgedeckt sind.

## Revendications

1. Réacteur plasmachimique à micro-ondes, comprenant :
une chambre de décharge métallique (1) en forme d'un tube cylindrique présentant un plateau supérieur (3), un plateau inférieur (2) et une paroi latérale (4),
une unité pour amener l'énergie de micro-ondes dans la chambre de décharge (1), cette unité étant réalisée par deux tubes métalliques coaxiaux (11, 12) composés d'un tube externe (12) comprenant un plateau supérieur (13), et un tube interne (11) ;
un agencement de transition (14) composé d'un corps métallique (16) sous forme de cône tronqué dont la grande base est une partie du plateau supérieur (3) de la chambre de décharge entourant le tube interne (11), et d'une enveloppe métallique (15) qui entoure coaxialement le corps métallique (16) et relie le tube externe (12) à la paroi latérale (4) de la chambre de décharge ;
un raccord de guide-ondes coaxial (7) dont l'enveloppe de conducteur externe (9) est reliée au plateau supérieur (13) de l'unité (10) pour introduire l'énergie de micro-ondes et est isolée par rapport au tube interne (11) par un anneau diélectrique (21),
dans lequel le conducteur central (8) forme une approche graduelle (20) de la surface terminale supérieure du tube interne (11) et est isolé par rapport à l'enveloppe (9) ; et qu'un support (6) pour y placer une charge et collecter un produit fini est positionné sur le plateau inférieur (2) de la chambre de décharge et est capable de se déplacer ;
une fenêtre diélectrique étanche disposée entre l'enveloppe (15) et le corps métallique (16) ;
un canal de guidage (26) d'un courant gazeux tourbillonnaire additionnel ;
une électrode d'amorçage (19) montée sur la paroi latérale (4) de la chambre de décharge, et des buses (17) pour introduire le gaz de travail positionnées tangentiellement par rapport aux parois latérales (4), et
des ouvertures d'évacuation du gaz (18) prévues dans le plateau inférieur (2),
**caractérisé en ce**
**qu'**un insert (27) en une matière conductrice et présentant une ouverture centrale est positionné dans la partie terminale du tube interne (11) du réacteur plasmachimique à micro-ondes, cet insert étant fixé à la surface interne du tube (11) en utilisant des saillies et étant réalisé essentiellement en forme de corps de révolution ;
**que** la seconde extrémité du conducteur central (8) du raccord de guide-ondes coaxial (7) est couplée à un débitmètre ; et
**que** ladite fenêtre diélectrique étanche est réalisée sous forme d'un cylindre diélectrique étanche (25) inséré entre la surface conique du corps métallique et la paroi du tube externe et coaxialement par rapport au tube ;
ledit canal de guidage (26) d'un courant gazeux tourbillonnaire additionnel étant positionné à l'intérieur de l'enveloppe (15) autour du cylindre diélectrique (25) ;
un tube métallique (5) étant positionné dans le centre du plateau inférieur de la chambre de décharge et étant adapté à un déplacement par rapport audit plateau (2) ;
ledit support (6) pour y placer une charge et collecter un produit fini étant positionné à l'intérieur dudit tube métallique (5) ;
l'insert conducteur (27) étant connecté au pôle négatif d'une source de tension, le tube métallique (5) étant relié au pôle positif de cette source de tension ; et
un solénoïde (29) étant positionné autour de la chambre de décharge (1).

2. Dispositif selon la revendication 1, **caractérisé en ce que** deux fenêtres (30) sont pratiquées dans la paroi externe du tube qui sont décalées horizontalement l'une de l'autre d'un angle de 90°, des guides-ondes rectangulaires (31) étant couplés à ces fenêtre de telle manière que leurs parois plus larges sont orientées le long de l'axe de la chambre de décharge (1), et que les fenêtres de connexion des guides-ondes sont recouvertes d'inserts diélectriques.
